(19) Europäisches Patentamt
European Patent Office
Office européen des brevets

(11) **EP 3 832 355 B1**

(12) **FASCICULE DE BREVET EUROPEEN**

(45) Date de publication et mention
de la délivrance du brevet:
**03.08.2022  Bulletin 2022/31**

(21) Numéro de dépôt: **20208070.1**

(22) Date de dépôt: **17.11.2020**

(51) Classification Internationale des Brevets (IPC):
**G01V 99/00** $^{(2009.01)}$      **G01V 1/30** $^{(2006.01)}$

(52) Classification Coopérative des Brevets (CPC):
**G01V 99/00**

(54) **PROCEDE POUR MODELISER UN BASSIN SEDIMENTAIRE, AU MOYEN D'UNE REPRESENTATION MAILLEE HEXA-DOMINANTE**

VERFAHREN ZUR MODELLIERUNG EINES SEDIMENTBECKENS MIT HILFE EINER HEXA-DOMINANTEN NETZDARSTELLLUNG

METHOD FOR MODELLING A SEDIMENTARY BASIN, USING A HEXA-DOMINANT MESH REPRESENTATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **05.12.2019  FR 1913785**

(43) Date de publication de la demande:
**09.06.2021  Bulletin 2021/23**

(73) Titulaires:
  • **IFP Energies nouvelles**
    **92852 Rueil-Malmaison Cedex (FR)**
  • **TotalEnergies OneTech**
    **92400 Courbevoie (FR)**

(72) Inventeur: **COLOMBO, Daniele**
    **92852 RUEIL-MALMAISON CEDEX (FR)**

(74) Mandataire: **IFP Energies nouvelles**
    **Département Propriété Industrielle**
    **Rond Point de l'échangeur de Solaize**
    **BP3**
    **69360 Solaize (FR)**

(56) Documents cités:
    **US-A1- 2017 177 764**

    • **LI Y H ET AL: "Highly accurate smoothed finite element methods based on simplified eight-noded hexahedron elements", ENGINEERING ANALYSIS WITH BOUNDARY ELEMENTS, vol. 105, 30 avril 2019 (2019-04-30), pages 165-177, XP085694954, ISSN: 0955-7997, DOI: 10.1016/J.ENGANABOUND.2019.03.020**
    • **NGUYEN-THOI T ET AL: "A face-based smoothed finite element method (FS-FEM) for visco-elastoplastic analyses of 3D solids using tetrahedral mesh", COMPUTER METHODS IN APPLIED MECHANICS AND ENGINEERING, NORTH-HOLLAND, AMSTERDAM, NL, vol. 198, no. 41-44, 1 septembre 2009 (2009-09-01), pages 3479-3498, XP026574218, ISSN: 0045-7825, DOI: 10.1016/J.CMA.2009.07.001 [extrait le 2009-07-12]**
    • **ZHANG GUOHUA ET AL: "Modelling three dimensional dynamic problems using the four-node tetrahedral element with continuous nodal stress", SCIENCE CHINA TECHNOLOGICAL SCIENCES, SCIENCE CHINA PRESS, HEIDELBERG, vol. 61, no. 12, 18 octobre 2018 (2018-10-18), pages 1889-1900, XP036661193, ISSN: 1674-7321, DOI: 10.1007/S11431-018-9305-5 [extrait le 2018-10-18]**

**Description**

**Domaine technique**

La présente invention concerne le domaine de l'exploration et de l'exploitation des gisements pétroliers ou de sites de stockage géologique de gaz.

L'exploration pétrolière consiste à rechercher des gisements d'hydrocarbures au sein d'un bassin sédimentaire. La compréhension des principes de la genèse des hydrocarbures et leurs liens avec l'histoire géologique du sous-sol, a permis la mise au point de méthodes d'évaluation du potentiel pétrolier d'un bassin sédimentaire.

La démarche générale de l'évaluation du potentiel pétrolier d'un bassin sédimentaire comporte des allers-retours entre :

- une prédiction du potentiel pétrolier du bassin sédimentaire, réalisée à partir d'informations disponibles concernant le bassin étudié (affleurements, campagnes sismiques, forages par exemple). Cette prédiction vise à mieux comprendre l'architecture et l'histoire géologique du bassin étudié, notamment à étudier si des processus de maturation et de migration d'hydrocarbures ont pu se mettre en place, à identifier les zones du sous-sol dans lesquelles ces hydrocarbures ont pu s'accumuler, à définir quelles zones présentent le meilleur potentiel économique, évalué à partir du volume et de la nature des hydrocarbures probablement piégés (viscosité, taux de mélange avec de l'eau, composition chimique, etc), ainsi que de leur coût d'exploitation (contrôlé par exemple par la profondeur et la pression de fluide).

- des forages d'exploration dans les différentes zones présentant le meilleur potentiel, afin de confirmer ou infirmer le potentiel prédit préalablement, et d'acquérir de nouvelles données pour alimenter de nouvelles études plus précises.

L'exploitation pétrolière d'un gisement consiste, à partir des informations récoltées lors de la phase d'exploration pétrolière, à sélectionner les zones du gisement présentant le meilleur potentiel pétrolier, à définir des schémas d'exploitation optimaux pour ces zones (par exemple à l'aide d'une simulation de réservoir, afin de définir les nombre et positions des puits d'exploitation permettant une récupération d'hydrocarbures optimale), à forer des puits d'exploitation et, de façon générale, à mettre en place les infrastructures de production nécessaires au développement du gisement.

Un bassin sédimentaire résulte du dépôt, au cours des temps géologiques, de sédiments au sein d'une dépression de la croûte terrestre. Ces sédiments, meubles et riches en eau vont être soumis, lors de leur enfouissement progressif dans le bassin, à des conditions de pression et de température qui vont les transformer en roches sédimentaires compactes, dites couches géologiques.

L'architecture au temps actuel d'un bassin sédimentaire résulte notamment d'une déformation mécanique du sous-sol au cours des temps géologiques. Cette déformation comporte a minima une compaction des couches géologiques, due à l'enfouissement progressif de ces couches au sein du bassin, sous l'effet de l'arrivée de nouveaux sédiments. Mais un bassin sédimentaire est également le plus souvent soumis à des mouvements tectoniques de grande ampleur, générant par exemple des plissements des couches géologiques, ou encore des failles venant créer une rupture dans les couches géologiques.

La nature des hydrocarbures présents dans un bassin sédimentaire quant à elle résulte notamment du type de matière organique présente dans les sédiments s'étant déposés, mais aussi des conditions de pression et de température auxquelles est soumis le bassin au cours des temps géologiques.

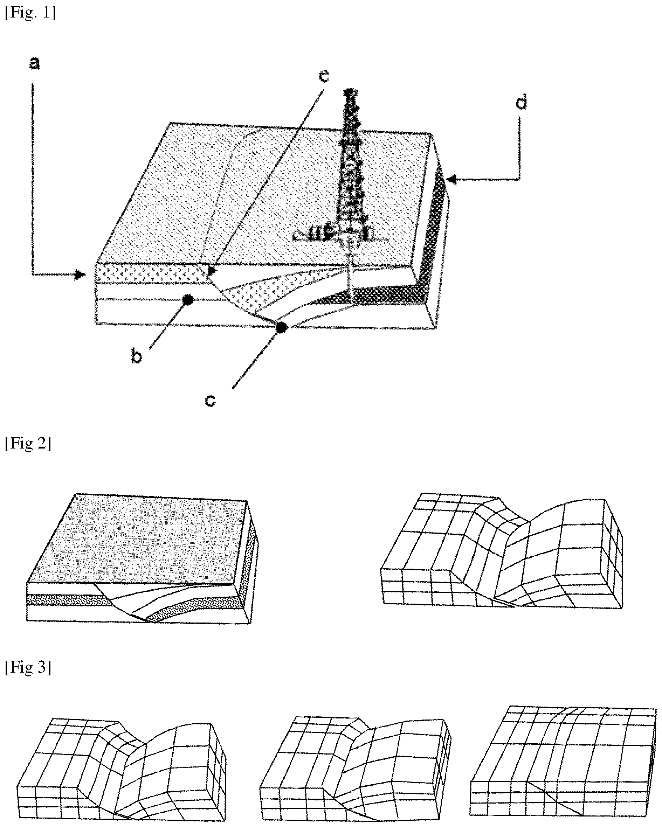

La Figure 1 montre une représentation schématique d'un bassin sédimentaire, comportant plusieurs couches géologiques (a, c), délimitées par des interfaces sédimentaires (b) traversées par une faille (e), et une accumulation d'hydrocarbures (d) dans une des couches géologiques du bassin considéré (c).

La formation d'un bassin sédimentaire implique donc un grand nombre de processus physiques et chimiques complexes, pouvant qui plus est interagir entre eux. Face à cette complexité, la prédiction du potentiel pétrolier d'un bassin sédimentaire requiert de disposer d'outils informatiques permettant de simuler, de la façon la plus réaliste possible, les phénomènes physiques et chimiques impliqués lors de la formation du bassin étudié.

Ce type de reconstitution de l'histoire de la formation d'un bassin sédimentaire, aussi appelée « modélisation de bassin », est le plus souvent réalisée à l'aide d'une famille d'outils informatiques permettant de simuler en une, deux ou trois dimensions, les processus sédimentaires, tectoniques, thermiques, hydrodynamiques et de chimie organique et inorganique qui interviennent lors de la formation d'un bassin pétrolier.

La modélisation de bassin comporte classiquement trois étapes :

- une étape de construction d'une représentation maillée du bassin étudié, connue sous le terme de géo-modélisation. Cette représentation maillée (aussi appelée maillage) est le plus souvent structurée en couches, c'est-à-dire qu'un groupe de mailles est affecté à chaque couche géologique du bassin modélisé. Puis, chaque maille de cette représentation maillée est remplie par une ou plusieurs propriétés pétrophysiques, telles que la porosité, le faciès (argile, sable, etc) ou encore leur teneur en matière organique au moment de leur sédimentation. La construction de ce modèle se base sur des données acquises au cours de campagnes sismiques, de mesures dans des puits, de carottages, etc.

- une étape de reconstruction structurale de cette représentation maillée, représentant des états antérieurs de l'architecture du bassin. Cette étape peut être réalisée à l'aide d'une méthode dite de "backstripping", ou encore par une méthode dite de restauration structurale.

- une étape de simulation numérique de phénomènes physiques se déroulant au cours de l'évolution du bassin et contribuant à la formation des pièges pétroliers. Cette étape, connue sous le terme de « simulation de bassin », s'appuie sur une représentation discrétisée de l'espace et du temps pour reconstituer la formation du bassin au cours des temps géologiques. En particulier, la simulation de bassin permet de simuler, au cours des temps géologiques, la formation des hydrocarbures à partir notamment de la matière organique initialement enfouie avec les sédiments, l'état des contraintes et des déformations dans le bassin, et le transport de ces hydrocarbures, depuis les roches dans lesquelles ils se sont formés jusqu'à celles où ils sont piégés. A l'issue d'une simulation de bassin, on obtient ainsi une cartographie du sous-sol au temps actuel, indiquant l'emplacement probable des gisements, ainsi que la teneur, la nature et la pression des hydrocarbures qui y sont piégés. Un exemple d'un tel simulateur de bassin est le logiciel TEMISFLOW® (IFP Énergies nouvelles, France).

Ainsi, cette démarche intégrée permettant la prise en compte et l'analyse des phénomènes à l'origine de la génération, de la migration et de l'accumulation des hydrocarbures dans les bassins sédimentaires permet d'augmenter le taux de succès lors d'un forage d'un puits d'exploration, et permet ainsi une meilleure exploitation de ce bassin.

## Technique antérieure

Les documents suivants seront cités au cours de la description :

Cook, Robert D., Finite Element Modeling for Stress Analysis, John Wiley & Sons, 1995.
Coussy, O., Mécanique des milieux poreux, Editions Technip, 1991, Paris.
Liu, G.R., Nguyen Thoi Trung, Smoothed Finite Element Methods, CRC Press, 2010.
Schneider F., Modelling multi-phase flow of petroleum at the sedimentary basin scale. Journal of Geochemical exploration 78-79 (2003) 693-696).
Steckler, M.S., and A.B. Watts, Subsidence of the Atlantic-type continental margin off New York, Earth Planet. Sci. Lett., 41, 1-13, 1978.
Zienkiewicz, O.C., Taylor, R.L., The finite element method - Volume 1 : the basis-Fifth Edition, Butterworth Heinemann, 2000. On connaît les documents suivants : - US 2017/177764 A1 qui concerne un procédé de modélisation de bassin, mis en œuvre au moyen d'un simulateur de bassin et d'un simulateur gêomécanique coopérant entre eux, et comprenant une étape de construction de représentations maillées ; - Li, Y H & Niu, R P & Liu, G R (2019) Highly accurate smoothed finite element methods based on simplificd eight-noded hexahedron éléments EngineeringAnalysis with Boundary Eléments. 105. 165-177 10.1016/j .enganabound 2019 03.020, qui concerne une méthode aux éléments finis lissée très précise basée sur des cléments hexaédriques simplifiés à 8 nœuds.

On connait des outils de simulation de bassin qui permettent de simuler numériquement la formation d'un bassin sédimentaire. On citera par exemple l'outil décrit dans le brevet EP2110686 (US8150669) ou les demandes de brevet EP2816377 (US2014/0377872), EP3075947 (US2016/0290107), EP3182176 (US2017/0177764). Ces outils permettent notamment d'estimer l'évolution de quantités telles que la température et la pression dans l'ensemble d'un bassin sédimentaire au cours des temps géologiques, et ainsi de simuler, au cours des temps géologiques, à la fois la transformation de la matière organique présente dans une roche mère du bassin en hydrocarbures, et la migration dans une roche réservoir du bassin des hydrocarbures ainsi produits.

Très classiquement, comme décrit par exemple dans le document (Schneider, 2003), les logiciels de simulation de bassin font une hypothèse de variations uniquement verticales des contraintes mécaniques affectant un bassin sédimentaire. Plus précisément, les logiciels de simulation de bassin ne prennent en compte que la composante verticale des variations de contraintes mécaniques induites par le poids des dépôts sédimentaires successifs au cours du temps. On parle alors de simulation 1D des effets mécaniques.

Toutefois, un bassin sédimentaire peut être soumis au cours de son histoire à des contraintes mécaniques caractérisées par des composantes dans les trois dimensions de l'espace, ces contraintes pouvant être locales ou régionales, et variables au cours du temps. Ces contraintes mécaniques sont d'une part induites par les dépôts de sédiments eux-mêmes. Dans ce cas, les contraintes mécaniques comportent une composante verticale, liée au poids des sédiments sur les couches déjà déposées, mais comportent le plus souvent également des composantes horizontales, ainsi que des composantes de cisaillement, les dépôts sédimentaires n'étant généralement pas invariants latéralement. D'autre part, un bassin sédimentaire subit, tout au long de sa formation, des contraintes mécaniques induites par des mouvements tectoniques liés à la géodynamique terrestre, tels que des mouvements en extension (provoquant l'ouverture du bassin avec par exemple la formation de rift) ou encore des mouvements en compression (provoquant des plissements, des chevauchements, des fractures au sein du bassin etc). Ces mouvements tectoniques induisent le plus souvent des variations de contraintes mécaniques dans les trois dimensions de l'espace. A noter qu'une couche déjà déposée va subir des variations de contraintes induites par les mouvements tectoniques auxquels est soumis un bassin sédimentaire tout au long de sa formation.

Ainsi, dans le cas de tels bassins, on a besoin d'une modélisation très précise du champ de contraintes et le modèle vertical n'est plus satisfaisant. On connait le document EP 3182176 (US 10296679) qui concerne un couplage entre un simulateur de bassin classique (c'est-à-dire comprenant une simulation 1D des effets mécaniques) et un simulateur mécanique, qui permet de déterminer et de tenir compte du champ de déplacement et des contraintes en 3 dimensions dans une simulation de modélisation de bassin. Le couplage décrit dans ce document permet de réaliser les calculs thermique, hydrodynamique et mécanique sur une seul et même représentation maillée.

De manière générale, les représentations maillées utilisées en simulation de bassin doivent être hexaèdres-dominants (ou encore hexa-dominant) et conformes aux limites entres couches stratigraphiques afin que les modélisations hydrodynamiques soient les plus précises possibles. Or, parfois, certains bassins comportent une succession de couches géologiques très fines (quelques mètres, alors que les dimensions classiques d'un modèle de bassin sont de l'ordre de la centaine de km dans les deux directions horizontales et de l'ordre de 10 à 20 km dans la direction verticale) ayant des propriétés mécaniques et hydrauliques très hétérogènes et/ou des couches stratigraphiques biseautées, caractéristiques qui doivent être prises en compte dans la représentation maillée du bassin en vue d'une simulation numérique précise.

Couches fines et biseaux sont deux objets géométriques qui rendent très complexe la génération du maillage à utiliser pour la modélisation de bassin, notamment pour la simulation du comportement mécanique. De manière classique, la simulation du comportement mécanique est réalisée par la méthode des éléments finis, aussi connue sous l'acronyme FEM ("Finite Element Method"). La qualité de la solution qu'on peut obtenir avec cette méthode dépend de la taille des mailles du maillage (la précision augmente avec le raffinement du maillage) et de leur forme. Dans le cas idéal, la géométrie de la maille doit être régulière et son rapport de forme (rapport entre les longueurs de sa plus petite arête et sa plus grande arête) doit être égale à 1 : une maille hexaédrique devrait être idéalement un cube, une maille tétraédrique devrait être idéalement un tétraèdre régulier, et ainsi de suite. En présence de couches fines et biseaux, le respect de ces conditions conduirait inévitablement à la génération de maillages avec un nombre très élevé de mailles, ce qui rend les algorithmes qui utilisent ces maillages inutilisables à cause de l'augmentation excessive de la demande en mémoire et en temps de calcul. Dans le cas des biseaux, il est même impossible de respecter la condition sur la géométrie de la maille, même en augmentant énormément le raffinement du maillage : la présence d'angles très faibles au niveau de l'extrémité du biseau fait apparaitre des mailles aplaties ou distordues indépendamment du niveau de raffinement. Dans certains cas, la géométrie défavorable de ces mailles crée des problèmes numériques qui empêchent la simulation d'aboutir.

Dans la pratique, en cas de couches fines ou de biseaux stratigraphiques, de manière à limiter le nombre de mailles à utiliser pour la simulation numérique, il est classique d'utiliser des mailles ayant une extension latérale de un à plusieurs kilomètres, alors qu'elles ne font que quelques mètres dans le sens vertical. Par ailleurs, la présence de biseaux stratigraphiques impose en plus d'être capable de traiter des mailles dont les faces sont raccordées suivant un angle très faible, de l'ordre de 1° par exemple. Ainsi, certains cas d'application pratique de la simulation numérique de bassin ne permettent pas de générer un maillage pour lequel les conditions sur la forme de la maille sont vérifiées, ce qui a pour conséquence que la qualité de la simulation numérique de bassin n'est pas garantie. Dans certain cas, il se peut même que la méthode numérique ne puisse trouver une solution.

Pour pallier ces inconvénients, il est possible d'utiliser la méthode FS-FEM (pour "Face-based Smoothed Finite Element Method"), ou méthode aux éléments finis lissée basée sur les faces. La méthode FS-FEM est une déclinaison de la méthode aux éléments finis lissée (S-FEM, pour "Smoothed Finite Element Method"), qui est elle-même une variante de la méthode FEM. Chaque déclinaison de la méthode S-FEM a ses propriétés de convergence et de précision. La déclinaison FS-FEM est connue comme étant la déclinaison de la méthode S-FEM la plus précise.

Toutefois, comme cela sera démontré ci-après, il s'avère que l'application de la méthode FS-FEM pour résoudre l'équation d'équilibre de la poromécanique est instable dans le cas d'un maillage hexa-dominant présentant des mailles aplaties (rapport de la plus petite arête verticale sur la plus grande arête verticale valant au plus 1/5, préférentiellement 1/10). Or, en pratique, afin de ne pas augmenter démesurément le nombre de mailles de la simulation numérique de bassin, les couches fines et les biseaux stratigraphiques sont bien souvent représentés par des mailles aplaties.

La présente invention vise à pallier ces inconvénients. En particulier, la présente invention permet de résoudre numériquement de manière stable et garantissant la qualité de la solution les équations impliquées dans une simulation numérique de bassin, en particulier l'équation d'équilibre de la poromécanique au moyen d'une méthode aux éléments finis lissée basée sur les faces, même dans le cas d'un maillage hexa-dominant représentant des couches fines et/ou des biseaux stratigraphiques.

**Résumé de l'invention**

La présente invention concerne un procédé de modélisation d'un bassin sédimentaire mis en œuvre par ordinateur, ledit bassin sédimentaire ayant subi une pluralité d'événements géologiques définissant une séquence d'états dudit bassin, au moyen d'une simulation numérique de bassin exécutée sur ordinateur, ladite simulation numérique de bassin résolvant au moins une équation d'équilibre de la poromécanique selon une méthode aux éléments finis lissée basée sur les faces pour déterminer au moins un champ de contrainte et un champ de déformation. Le procédé selon l'invention comprend la mise en œuvre d'au moins les étapes suivantes :

A. on réalise des mesures de grandeurs physiques relatives audit bassin au moyen de capteurs, et on construit une première représentation maillée représentative dudit bassin pour chacun desdits états dudit bassin, lesdites premières représentations maillées dudit bassin pour chacun desdits états étant majoritairement formées par des mailles hexaédriques ;

B. au moyen de ladite simulation numérique de bassin et desdites premières représentations maillées pour chacun desdits états, on détermine au moins un champ de déformation et un champ de contrainte pour chacun desdits états en appliquant au moins les étapes suivantes pour chacune desdites premières représentations maillées desdits états :

a) on détermine une deuxième représentation maillée dudit état en subdivisant chacune desdites mailles hexaédriques de ladite première représentation maillée dudit état en six mailles pyramidales, lesdites mailles non hexaédriques de ladite première représentation maillée étant inchangées dans ladite deuxième représentation maillée ;

b) on modélise ledit bassin en déterminant au moins ledit champ de déplacement et ledit champ de contrainte pour ledit état au moyen de ladite simulation numérique appliquée à ladite deuxième représentation maillée dudit état.

Selon une mise en œuvre de l'invention, on peut subdiviser une maille hexaédrique de ladite première représentation maillée en six mailles pyramidales en reliant, pour chacune des faces de ladite maille hexaédrique; chacun des nœuds de ladite face à un nœud supplémentaire placé au barycentre de ladite maille hexaédrique.

Selon une mise en œuvre de l'invention, on peut, à l'étape b), pour chacune des faces de chacune desdites mailles de ladite deuxième représentation maillée dudit état, déterminer un domaine de lissage relatif à ladite méthode aux éléments finis lissée basée sur les faces en reliant chacun des nœuds de ladite face à au moins un nœud supplémentaire placé au barycentre de ladite au moins une maille à laquelle appartient ladite face.

Selon une mise en œuvre de l'invention, ledit domaine de lissage pour une face appartenant à au moins une maille pyramidale de ladite deuxième représentation maillée peut correspondre à au moins un tétraèdre ou une pyramide.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé tel que décrit ci-dessus, lorsque ledit programme est exécuté sur un ordinateur.

L'invention concerne également un procédé pour exploiter des hydrocarbures présents dans un bassin sédimentaire, ledit procédé comprenant au moins la mise en œuvre du procédé de modélisation dudit bassin tel que décrit ci-dessus, et dans lequel, à partir au moins de ladite modélisation dudit bassin sédimentaire, on détermine un schéma d'exploitation dudit bassin comprenant au moins une implantation d'au moins un puits injecteur et/ou d'au moins un puits producteur, et on exploite lesdits hydrocarbures dudit bassin au moins en forant lesdits puits de ladite implantation et en les équipant d'infrastructures d'exploitation.

D'autres caractéristiques et avantages du procédé selon l'invention, apparaîtront à la lecture de la description ci-après d'exemples non limitatifs de réalisations, en se référant aux figures annexées et décrites ci-après.

**Liste des figures**

La figure 1 présente de manière illustrative un bassin sédimentaire.

La Figure 2 montre un exemple de bassin sédimentaire (à gauche) et un exemple de représentation maillée (à droite) de ce bassin.

La Figure 3 montre un exemple de reconstruction structurale d'un bassin sédimentaire selon un mode de réalisation de l'invention, représenté par trois états de déformations pris à trois états géologiques différents.

La Figure 4 présente la déformation d'une poutre soumise à une flexion calculée par la méthode FEM et par la méthode FS-FEM, dans le cas de mailles hexaédriques aplaties.

La Figure 5 présente un exemple de mise en œuvre de subdivision d'une maille hexaédriques en six mailles pyramidales.

## Description des modes de réalisation

Selon un premier aspect, l'invention concerne un procédé mis en œuvre par ordinateur de modélisation d'un bassin sédimentaire, au moyen au moins d'une simulation numérique de bassin résolvant au moins une équation d'équilibre de la poromécanique selon une méthode aux éléments finis lissée basée sur les faces, encore connue sous l'acronyme FS-FEM ("Face-based Smoothed Finite Element Method").

De manière générale, l'équation d'équilibre de la poromécanique s'écrit (cf. par exemple le document (Coussy, 1991)):

$$\nabla \cdot \underline{\underline{\sigma}}' + (\rho + m)\underline{g} = \nabla \cdot \left(p\underline{\underline{B}}\right)$$

où $\underline{\underline{\sigma}}'$ est le tenseur de la contrainte effective, $\rho$ la densité homogénéisée du milieux poreux, $m$ l'échange de masse fluide, $\underline{g}$ l'accélération de gravité, $p$ la pression fluide et $\underline{\underline{B}}$ le tenseur de Biot. Dans une simulation numérique telle qu'une simulation de bassin, cette équation est résolue numériquement. De manière générale, cette équation est généralement discrétisée sur une représentation maillée (ou maillage) à l'aide de la méthode aux éléments finis (FEM, pour "Finite Element Method") ou de l'une de ses variantes, comme par exemple la méthode aux éléments finis lissée (S-FEM, pour "Smoothed Finite Element Method").

Différentes déclinaisons de la méthode S-FEM existent dans la littérature du domaine de la simulation mécanique, chacune avec ses propriétés de convergence et précision. La déclinaison dite FS-FEM (pour "Face-based Smoothed Finite Element Method"), ou méthode aux éléments finis lissée basée sur les faces, est connue comme étant la déclinaison de la méthode S-FEM la plus précise. Toutefois, dans la littérature, la méthode FS-FEM est décrite à ce jour uniquement pour des mailles tétraédriques, et tous les cas d'application qu'on retrouve dans la littérature du domaine de la simulation mécanique utilisent un maillage tétraédrique uniquement.

La demanderesse a constaté que la méthode FS-FEM est en pratique instable dans le cas d'un maillage comprenant des mailles hexaédriques très aplaties. Ainsi, il s'avère que la méthode FS-FEM ne peut être appliquée en l'état dans le cas de modèles de bassin dont la représentation maillée comportent des mailles représentatives de couches géologiques de faibles épaisseurs (par exemple de l'ordre de quelques mètres dans la direction verticale) et/ou lorsque ces couches présentent des biseaux stratigraphiques (par exemple caractérisés par un angle inférieur à 1°).

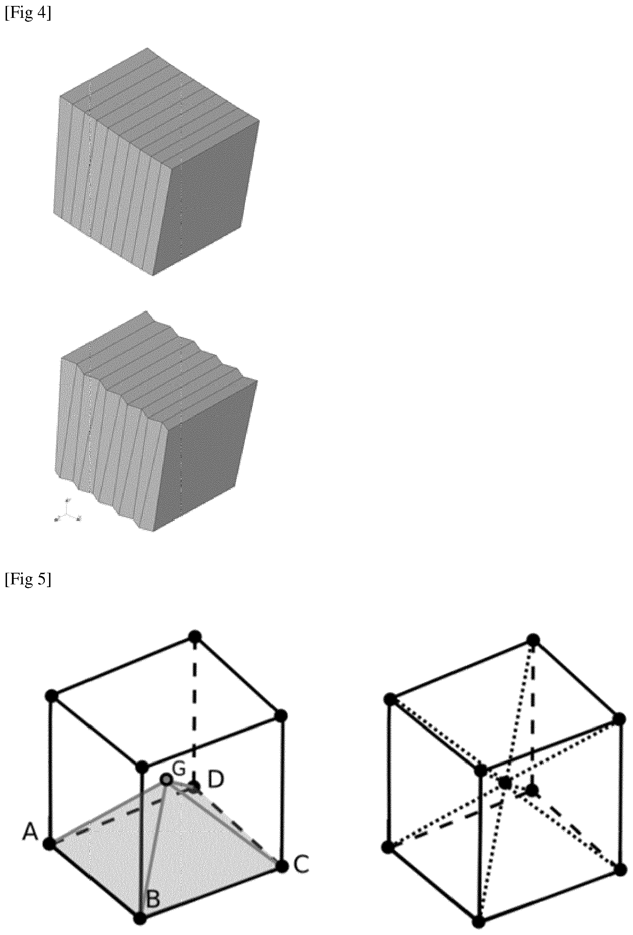

L'instabilité de la méthode FS-FEM en présence de mailles hexaédriques aplaties (c'est-à-dire dont le rapport de la plus grand arête horizontale sur la plus petite arête verticale vaut au moins 5, préférentiellement 10) se concrétise de deux façons différentes dans les simulations numériques : soit le calcul s'arrête avec une erreur fatale car la matrice de rigidité du modèle est singulière (déterminant nul), ce qui signifie qu'elle ne peut pas être inversée, soit la solution calculée est erronée et présente localement des oscillations et/ou des pics dans les déplacements, contraintes et déformations calculés. Un exemple de ce dernier cas est présenté en figure 4, dans le cadre d'une poutre soumise à une flexion, la poutre étant représentée au moyen de mailles constituées par des hexaèdres aplatis (rapport de forme de 1 sur 10). Plus précisément, la figure 4 haut présente la géométrie de la poutre déformée calculée avec la méthode FEM. Cette déformée est correcte car cohérente avec la solution analytique connue du problème. La figure 4 bas présente la géométrie de la poutre déformée obtenue avec la méthode FS-FEM : la déformation est clairement incorrecte et la forme en accordéon est le signe typique de l'instabilité numérique (voir aussi le paragraphe 4.6 du document (Cook, 1995).

La présente invention concerne un perfectionnement de la méthode FS-FEM, de manière à la rendre applicable aux mailles hexaédriques utilisées dans les modèles de bassin. En particulier, de manière particulièrement astucieuse, la demanderesse a montré que le perfectionnement de la méthode FS-FEM selon l'invention permet de stabiliser la simulation numérique, y compris dans le cas de mailles hexaédriques aplaties.

Ainsi, la simulation numérique de bassin selon l'invention vise à résoudre numériquement au moins l'équation d'équilibre de la poromécanique selon la méthode aux éléments finis lissée basée sur les faces (FS-FEM), et ce, dans le cas d'une représentation maillée de type hexa-dominant.

De manière générale, la discrétisation de l'équation d'équilibre de la poromécanique conduit à l'écriture d'un système d'équations algébriques qui a la forme suivante (cf. par exemple l'équation 2.23 du document (Zienkiewicz and Taylor, 2000)) :

$$\boxed{\mathbf{Ka} + \mathbf{f} = \mathbf{r}} \tag{1}$$

où K est la matrice de rigidité du système (*"stiffness matrix"*), a est le vecteur des degrés de liberté des nœuds du maillage utilisé pour la discrétisation (*"nodal displacements"*, cf. équation 2.1 du document (Zienkiewicz and Taylor, 2000)), f est un vecteur des forces nodales ("equivalent nodal forces ", cf équation 2.24b dans le document (Zienkiewicz and Taylor, 2000)) et r est le vecteur des forces externes ponctuelles (*"external concentrated forces", cf. équation 2.14* du document (Zienkiewicz and Taylor, 2000)). Les détails de la résolution de ce système d'équations par une méthode des éléments finis lissée basée sur les faces spécifiquement adaptée au cas de mailles hexaédriques sont donnés dans l'étape 2 du procédé selon l'invention.

Selon l'invention, on considère que le bassin sédimentaire a subi une pluralité d'événements géologiques définissant une séquence d'états du bassin, chacun desdits états s'étendant entre deux événements géologiques successifs. De manière préférée, la séquence d'états peut couvrir une période de temps couvrant au moins la production d'hydrocarbures, notamment par maturation d'une matière organique présente dans une roche-mère du bassin, la déformation du bassin due à des contraintes mécaniques 3D, le déplacement de ces hydrocarbures produits vers au moins une roche réservoir du bassin au cours des temps géologiques. Par la suite et de manière non limitative, on note Ai un état de la séquence d'états du bassin, i étant un entier variant de 1 à n, An représentant l'état du bassin au temps actuel. Selon l'invention, n vaut au moins 2. Autrement dit, la séquence d'états selon l'invention comprend l'état du bassin au temps actuel et au moins un état dudit bassin à un temps géologique antérieur.

Selon un deuxième aspect, l'invention concerne un procédé pour exploiter des hydrocarbures présents dans un bassin sédimentaire, le procédé selon le deuxième aspect comprenant la mise en œuvre du procédé de modélisation d'un bassin sédimentaire selon le premier aspect de l'invention.

Le procédé selon le premier aspect de l'invention comprend au moins les étapes 1) et 2) décrites ci-après.

Le procédé selon le deuxième aspect de l'invention comprend au moins les étapes 1) à 3) décrites ci-après.

**1) Construction de représentations maillées pour chacun des états**

Au cours de cette étape, on réalise des mesures de grandeurs physiques relatives au bassin au moyen de capteurs, on construit une représentation maillée représentative du bassin au temps actuel puis des représentations maillées pour chacun des états du bassin. Selon l'invention, les représentations maillées du bassin pour chacun desdits états sont majoritairement formées par des mailles hexaédriques. On parle classiquement de maillage hexa-dominant.

Au cours de cette étape, on applique au moins les trois sous-étapes suivantes :

**1.1) Mesures de grandeurs physiques relatives au bassin**

Au cours de cette sous-étape, il s'agit d'acquérir des mesures de grandeurs physiques relatives au bassin étudié, au moyen de capteurs.

De manière non limitative, les capteurs peuvent consister en des outils de mesures diagraphiques, en des sources et récepteurs sismiques, en des préleveurs et analyseurs de fluide, etc.

Ainsi, les mesures selon l'invention peuvent consister en des études d'affleurement, des campagnes d'acquisition sismique, des mesures dans des puits (par diagraphies par exemple), des analyses pétrophysiques et/ou géochimiques de carottes prélevées in situ.

A partir de ces mesures, on peut en déduire des propriétés pétrophysiques associées au bassin étudié, tels que le faciès (lithologie), la porosité, la perméabilité, ou encore la teneur en matière organique en des points de mesure du bassin. On peut aussi obtenir des informations sur les propriétés des fluides présents dans le bassin, telles que des valeurs de saturation des différents fluides présents dans le bassin. Egalement, on peut mesurer des températures en différents points du bassin (températures de fond de puit notamment).

**1.2) Construction d'une représentation maillée représentative du bassin à l'état actuel**

Au cours de cette sous-étape, il s'agit de construire une représentation maillée hexa-dominante représentative du bassin à l'état actuel, à partir des mesures des grandeurs physiques réalisées à la sous-étape précédente.

Plus précisément, la construction d'une représentation maillée d'un bassin consiste à discrétiser en trois dimensions l'architecture du bassin, à attribuer des propriétés à chacune des mailles de cette représentation maillée. Pour ce faire, on exploite notamment les mesures des grandeurs physiques réalisées en différents points du bassin telles que décrites ci-dessus, que l'on extrapole et/ou interpole, en les différentes mailles de la représentation maillée, suivant des hypothèses plus ou moins restrictives.

Le plus souvent la discrétisation spatiale d'un bassin sédimentaire est organisée en couches de mailles, représentant chacune les différentes couches géologiques du bassin étudié. La Figure 2 illustre à gauche un exemple de bassin sédimentaire au temps actuel, et à droite un exemple de représentation maillée de ce bassin.

Selon une mise en œuvre de l'invention, la représentation maillée pour l'état actuel An du bassin donné comprend notamment en chaque maille une information sur la lithologie, une valeur de porosité, une valeur de perméabilité, une teneur en matière organique, ainsi que des propriétés relatives aux fluides présents dans la maille, telles que la saturation.

Selon une mise en œuvre de l'invention, la représentation maillée pour l'état actuel An du bassin est majoritairement formées par des mailles hexaédriques. On peut pour ce faire utiliser le logiciel OPENFLOW® (IFP Énergies nouvelles, France) ou encore le logiciel GOCAD® (Emerson-Paradigm, USA).

**1.3) Reconstruction structurale de l'architecture du bassin pour les différents états**

Au cours de cette sous-étape, il s'agit de reconstruire les architectures passées du bassin pour les différents états Ai, avec i variant de 1 à n-1. Pour ce faire, on déforme la représentation maillée construite à la sous-étape précédente, qui représente le bassin au temps actuel, afin de représenter l'évolution anti-chronologique de l'architecture du sous-sol au cours des temps géologiques, et ce pour les différents états Ai. A l'issue de cette sous-étape, on dispose d'une représentation maillée pour chaque état Ai, avec i variant de 1 à n.

Selon un premier mode de réalisation de la présente invention, la reconstruction structurale peut être particulièrement simple si elle se base sur l'hypothèse que sa déformation résulte uniquement d'une combinaison de mouvements verticaux par compaction du sédiment ou par surrection ou affaissement de son socle. Cette technique, connue sous le terme de "backstripping" (ou "décompaction progressive du bassin" en français) est décrite par exemple dans (Steckler et Watts, 1978).

Selon un autre mode de réalisation de la présente invention, dans le cas de bassins dont l'histoire tectonique est complexe, notamment dans le cas de bassins présentant des failles, il convient d'utiliser des techniques aux hypothèses moins restrictives, telles que la restauration structurale. Une telle restauration structurale est décrite par exemple dans le document FR 2930350 A1 (US 2009/0265152 A1). La restauration structurale consiste à calculer les déformations successives que le bassin a subies, en intégrant les déformations dues à la compaction et celles qui résultent des forces tectoniques.

Dans l'exemple de la Figure 3, trois états sont utilisés pour représenter la déformation du sous-sol au cours des temps géologiques. La représentation maillée de gauche représente l'état actuel, où l'on peut observer une interface de glissement (ici une faille). La représentation maillée de droite représente le même bassin sédimentaire pour un état Ai, antérieur à l'état actuel. Pour cet état Ai, les couches sédimentaires n'étaient pas encore fracturées. La représentation maillée centrale est un état intermédiaire, c'est-à-dire qu'elle représente le bassin sédimentaire à un état Ai', compris entre l'état Ai et l'état actuel. On constate que le glissement le long de la faille a commencé à modifier l'architecture du bassin.

**2) Détermination d'un champ de déformation et de contrainte par simulation numérique de bassin pour chacun des états**

Au cours de cette étape, au moyen de la simulation numérique de bassin et des représentations maillées déterminées pour chacun des états tel que décrit à l'étape précédente, on détermine au moins un champ de déformation et un champ de contrainte pour chacun des états.

Par la suite, on appelle "première représentation maillée" d'un état une représentation maillée telle que construite à l'étape 1 pour ledit état. L'étape 2 selon l'invention comprend au moins l'application à chacun des états des sous-étapes 2.1 et 2.2 décrites ci-après. Au cours de la sous-étape 2.1, qui est appliquée pour un état donné, on construit une deuxième représentation maillée de cet état, à partir de la première représentation maillée de cet état. Au cours de la sous-étape 2.2, qui est appliquée pour un état donné, on applique la simulation numérique de bassin selon l'invention, résolvant au moins une équation d'équilibre de la poromécanique selon la méthode aux éléments finis lissée basée sur les faces, à la deuxième représentation maillée de l'état considéré. Les sous-étapes 2.1 et 2.2 sont répétées pour chacun des états.

**2.1) Détermination d'une deuxième représentation maillée pour un état**

Au cours de cette sous-étape, on construit une deuxième représentation maillée d'un état en subdivisant chacune des mailles hexaédriques de la première représentation maillée de cet état en six mailles pyramidales (il s'agit de pyramides ayant une base de la forme d'un quadrilaètre, c'est-à-dire des pyramides comportant cinq faces et cinq sommets). Il est bien clair que les mailles non hexaédriques de la première représentation maillée considérée ne font pas l'objet d'une subdivision telle que décrite dans cette sous-étape. Les mailles non hexaédriques de la première représentation maillée considérée sont simplement reportées, avec toutes leurs caractéristiques de dimension et de position, dans la deuxième représentation maillée. Autrement dit, les mailles non hexaédriques de la première représentation maillée considérée sont inchangées dans la deuxième représentation maillée.

Selon une mise en œuvre préférée de l'invention, on peut subdiviser chacune des mailles hexaédriques de la première représentation maillée en six mailles pyramidales de la manière suivante : pour chaque face de la maille hexaédrique considérée, on relie chacun des nœuds de cette face à un nœud supplémentaire placé au barycentre de la maille hexaédrique considérée.

La figure 5 à gauche présente en grisé une maille pyramidale déterminée selon ce mode préféré de mise en œuvre de l'invention, formée à partir de la face ABCD d'une maille hexaédrique de la première représentation maillée et du barycentre G de cette maille hexaédrique. La figure 5 à droite présente les six mailles pyramidales formées à partir de chacune des faces d'une maille hexaédrique de la première représentation maillée selon ce mode préféré de mise en œuvre de l'invention, les traits en pointillé fin représentant les connections entre les nœuds de chacune des faces de la maille hexaédrique avec le nœud placé au barycentre G de cette maille hexaédrique.

Cette sous-étape est répétée pour chaque maille hexaédrique de la première représentation maillée d'un état. Les mailles non hexaédriques de la première représentation maillée sont inchangées dans la deuxième représentation maillée.

2.2) Détermination du champ de déplacement et du champ de contrainte pour la représentation maillée d'un état

Au cours de cette sous-étape qui est appliquée pour un état donné, on détermine le champ de déplacement et le champ de contrainte, au moyen de ladite simulation numérique de bassin selon l'invention résolvant au moins l'équation d'équilibre de la poromécanique selon la méthode FS-FEM appliquée à la deuxième représentation maillée de l'état considéré déterminée à la sous-étape précédente.

Autrement dit, on applique la méthode aux éléments finis lissée basée sur les faces telle que décrite dans la littérature, et notamment dans le document (Liu and Nguyen Thoi Trung, 2010), à la deuxième représentation maillée d'un état.

Nous décrivons toutefois ci-après les principales étapes, notées 2.2.1 à 2.2.4, à mettre en œuvre pour appliquer la méthode aux éléments finis lissée basée sur les faces telle que décrite dans la littérature à la deuxième représentation maillée d'un état.

2.2.1) Détermination d'un domaine de lissage pour chaque face de chaque maille de la deuxième représentation maillée d'un état

Au cours de cette sous-étape de la méthode FS-FEM appliquée à la deuxième représentation maillée selon l'invention, pour chacune des faces de chacune des mailles de la deuxième représentation maillée déterminée à la sous-étape précédente, on détermine un domaine de lissage relatif à la méthode des éléments finis lissée basée sur les faces.

De manière générale, la méthode des éléments finis lissée basée sur les faces (méthode FS-FEM), et plus généralement la méthode des éléments finis lissée (méthode S-FEM), utilise, dans la formulation de l'équilibre mécanique, une déformation lissée calculée par une moyenne pondérée de la déformation selon une équation du type (cf. par exemple l'équation 4.19 du document (Liu and Nguyen Thoi Trung, 2010)) :

$$\overline{\mathbf{\varepsilon}}(\mathbf{x}_k) = \frac{1}{A_k^s} \int\limits_{\Omega_k^s} \tilde{\mathbf{\varepsilon}}(\mathbf{x})\, \mathrm{d}\Omega, \qquad (2)$$

où $\overline{\varepsilon}$ est la déformation lissée de la méthode S-FEM ou de la méthode FS-FEM, $\tilde{\varepsilon}$ est la déformation (utilisée par la méthode FEM) et $A_k^S$ est le volume d'un domaine de lissage $\Omega_k^S$ sur lequel la déformation est lissée.

Selon ces méthodes, dont on trouve une description dans le document (Liu and Nguyen Thoi Trung, 2010), l'équation (2) ci-dessus est calculée sur chaque domaine de lissage. Les domaines de lissage pour la méthode S-FEM ou encore la méthode FS-FEM sont déterminés de telle manière que :

- les domaines de lissage couvrent entièrement le maillage ;

- il n'y a pas de recouvrement entre les domaines.

De manière classique pour la méthode S-FEM ou encore la méthode FS-FEM, on forme un domaine de lissage relatif à une face appartenant à au moins une maille quelconque en reliant les nœuds de la face considérée avec le ou les points correspondant aux barycentres des mailles auxquelles appartient la face considérée. Les domaines de lissage associés à chacune des faces des mailles de la deuxième représentation maillée sont créés selon ce même principe général.

A titre d'exemple, on détermine un domaine de lissage relatif à une face appartenant à une seule maille pyramidale (autrement dit une face libre, sur le bord de la représentation maillée) en formant au moins un tétraèdre ou une pyramide à partir des nœuds de ladite face et d'un point placé au barycentre de la maille pyramidale considérée. Il est bien clair que le domaine de lissage d'une face appartenant à une seule maille pyramidale correspond à un tétraèdre lorsque la face considérée est un des quatre triangles de la pyramide, et que le domaine de lissage d'une face appartenant à une seule maille correspond à une pyramide lorsque la face considérée est le quadrangle (c'est-à-dire la base) de la pyramide. Il est également bien clair que pour une face appartenant à deux mailles pyramidales voisines, le domaine de lissage est composé de deux tétraèdres ou de deux pyramides, car les nœuds d'une face sont alors reliés aux barycentres de chacune des mailles voisines.

La détermination d'un domaine de lissage selon ces principes est répétée pour chaque face des mailles de la deuxième représentation maillée d'un état.

## 2.2.2 Détermination d'une relation entre déformations et déplacements pour chaque domaine de lissage

Au cours de cette sous-étape de la méthode FS-FEM appliquée à la deuxième représentation maillée selon l'invention, pour chacun des domaines de lissage déterminés tel que décrit ci-dessus, on détermine une relation entre déformations et déplacements selon la méthode des éléments finis lissée basée sur les faces appliquée aux domaines de lissage tels que déterminés ci-dessus. Par "appliquée aux domaines de lissage" , on entend que la méthode des éléments finis lissée basée sur les faces est appliquée telle que décrite de manière générale dans la littérature.

Selon une mise en œuvre de l'invention, ladite relation entre déformation et déplacement prend la forme d'une matrice reliant le vecteur des déplacements à un vecteur des déformations. Cette matrice est aussi appelée matrice de transformation des déplacements en déformations ("strain-displacement transformation").

Selon une mise en œuvre de l'invention, l'utilisation de l'équation (2) ci-dessus pour la définition de la déformation lissée conduit à l'expression suivante pour la matrice de transformation des déplacements en déformations, notée B (cf. aussi les équations 4.29, 4.30 et 4.31 du document (Liu and Nguyen Thoi Trung, 2010)) :

$$B = [B_1 B_2 \dots B_{n-1} B_n] \ (3)$$

avec

$$B_i = \frac{1}{A_k^S} \int_{\partial \Omega_k^S} n N_i \, d\Gamma \ (4)$$

où $B_1 \dots B_n$ sont les matrices associées respectivement aux nœuds i=1..n de la ou des mailles auxquelles appartient le domaine de lissage $\Omega_k^S$ , $A_k^S$ est le volume du domaine de lissage $\Omega_k^S$ , $\partial \Omega_k^S$ est la frontière du domaine de lissage, n est la normale sortante du domaine de lissage $\Omega_k^S$ et Ni est la fonction de forme ("shape function" ; cf. paragraphe 2.2.1 du document (Zienkiewicz and Taylor, 2000)) associée au nœud i.

## 2.2.3 Détermination d'une rigidité et des forces nodales pour chacun des domaines de lissage

Au cours de cette sous-étape de la méthode FS-FEM appliquée à la deuxième représentation maillée selon l'invention, on détermine une rigidité et des forces nodales pour chacun des domaines de lissage déterminés tel que décrit ci-dessus, à partir au moins de la relation entre déformations et déplacements déterminée pour ce même domaine de lissage tel que décrit ci-dessus.

Selon une mise en œuvre de l'invention, ladite rigidité et lesdites forces nodales peuvent prendre la forme respectivement d'une matrice de rigidité et d'un vecteur de forces nodales.

Selon une mise en œuvre de l'invention, la matrice de rigidité $K_\Omega$ et le vecteur des forces nodales $f_\Omega$ relatifs à un domaine de lissage construit tel que décrit ci-dessus peuvent être déterminés au moyen des équations 2.24a, 2.24b du document (Zienkiewicz and Taylor, 2000), et en utilisant la matrice de transformation des déplacements en déformations B déterminée tel que décrit ci-dessus.

De manière générale dans la méthode FS-FEM, pour un domaine de lissage noté V, la matrice de rigidité K est calculée selon l'équation 2.24a du document (Zienkiewicz and Taylor, 2000)

$$\mathbf{K} = \int_V \mathbf{B}^{\mathrm{T}} \mathbf{D} \mathbf{B} \, \mathrm{d}V \tag{5}$$

où B est la matrice telle que décrite ci-dessus, D est une matrice représentative de la rigidité du matériau (cf. équation 2.5 du document (Zienkiewicz and Taylor, 2000)) calculée avec la loi de comportement du matériau qui lie les contraintes et les déformations.

De manière générale dans la méthode FS-FEM, pour un domaine de lissage noté V, le vecteur des forces nodales f est calculé selon l'équation 2.24b du document (Zienkiewicz and Taylor, 2000) :

$$\mathbf{f} = -\int_V \mathbf{N}^{\mathrm{T}} \mathbf{b} \, \mathrm{d}V - \int_A \mathbf{N}^{\mathrm{T}} \bar{t} \, \mathrm{d}A - \int_V \mathbf{B}^{\mathrm{T}} \mathbf{D} \boldsymbol{\varepsilon}_0 \, \mathrm{d}V + \int_V \mathbf{B}^{\mathrm{T}} \boldsymbol{\sigma}_0 \, \mathrm{d}V \tag{6}$$

où N est la matrice des fonctions de forme de l'élément fini de la maille parent décrit ci-dessus, b est le vecteur des forces volumiques ("body forces"), $\bar{t}$ le vecteur des forces surfaciques ("distributed external loading"), $\varepsilon_0$ la déformation initiale ("initial strains"; cf. paragraphe 2.2.3 du document (Zienkiewicz and Taylor, 2000)) et $\sigma_0$ la contrainte résiduelle initiale ("initial residual stresses" ; cf. paragraphe 2.2.3 du document (Zienkiewicz and Taylor, 2000)).

**2.2.4) Détermination d'une rigidité et des forces nodales pour la deuxième représentation maillée d'un état**

Au cours de cette sous-étape de la méthode FS-FEM appliquée à la deuxième représentation maillée, on détermine une rigidité et des forces nodales relatives à la deuxième représentation maillée de l'état considéré à partir au moins de la rigidité et des forces nodales déterminées pour chacun des domaines de lissage tel que décrit ci-dessus.

Selon une mise en œuvre de l'invention dans laquelle la rigidité et/ou les forces nodales peuvent prendre la forme respectivement d'une matrice de rigidité et d'un vecteur des forces nodales, on assemble les matrices de rigidité $K_\Omega$ et les vecteurs $f_\Omega$ déterminés pour chaque domaine de lissage $\Omega$ au cours de la sous-étape précédente au moyen d'un assemblage ("assembly" en anglais) standard utilisé dans la méthode des éléments finis (cf. paragraphe 1.3 du document (Zienkiewicz and Taylor, 2000)), et qui peut s'écrire de la manière suivante :

$$K = \sum_{i=1}^{n} K_\Omega \tag{7}$$

$$f = \sum_{i=1}^{n} f_\Omega \tag{8}$$

où n est le nombre total de domaines de lissage $\Omega$.

Puis, selon l'invention, on modélise le bassin sédimentaire étudié en déterminant au moins le champ de déplacement et le champ de contrainte pour la représentation maillée considérée, au moyen de la simulation numérique de bassin selon l'invention et au moins de la rigidité et des forces nodales déterminées pour la deuxième représentation maillée considérée et déterminées tel que décrit ci-dessus.

Selon une mise en œuvre de l'invention, on résout le problème discrétisé défini par l'équation (1) ci-dessus implémentée dans le simulateur de bassin selon l'invention, et mis en œuvre avec la matrice de rigidité K déterminée tel que décrit ci-dessus (et par exemple calculée par l'équation (7) ci-dessus), et le vecteur des forces nodales f déterminé tel que décrit ci-dessus (et par exemple calculé par l'équation (8) ci-dessus). La détermination du vecteur r de l'équation (2), qui est le vecteur des conditions aux limites, peut être réalisée selon la méthode FEM classique, et par exemple tel que décrit dans le paragraphe 1.3 du document (Zienkiewicz and Taylor, 2000).

Selon l'invention, au moins les sous-étapes 2.1 et 2.2 sont répétées pour chaque première représentation maillée représentative de chaque état du bassin.

## 3) Exploitation des hydrocarbures du bassin

Cette étape est mise en œuvre dans le cadre du deuxième aspect de l'invention, qui concerne un procédé pour exploiter des hydrocarbures présents dans un bassin sédimentaire.

A l'issue de la mise en œuvre des précédentes étapes, on dispose de résultats de simulation de bassin. La simulation de bassin selon l'invention permet au moins de déterminer le champ des contraintes et des déformations du bassin pour différents états du bassin, et ce, de manière stable dans le cas d'un maillage hexa-dominant dont certaines mailles présentent un mauvais rapport de forme.

De manière implicite, et comme cela est classique en simulation de bassin, on dispose en outre de la quantité des hydrocarbures présents dans chacune des mailles de la représentation maillée du bassin pour les temps passés et au temps actuel.

En outre, en fonction du simulateur de bassin utilisé pour mettre en œuvre l'invention, on peut disposer par exemple d'informations sur :

    i. la mise en place des couches sédimentaires,
    ii. leur compaction sous l'effet du poids des sédiments sus-jacents,
    iii. l'évolution de leur température au cours de leur enfouissement,
    iv. les modifications de pressions de fluides résultant de cet enfouissement,
    v. la formation des hydrocarbures formés par thermogénèse.

A partir de telles informations, le spécialiste peut alors déterminer des mailles de la représentation maillée du bassin au temps actuel comportant des hydrocarbures, ainsi que la teneur, la nature et la pression des hydrocarbures qui y sont piégés. On peut alors sélectionner les zones du bassin étudié présentant le meilleur potentiel pétrolier. Ces zones sont alors identifiées comme des réservoirs (ou encore des gisements d'hydrocarbures) du bassin sédimentaire étudié.

Au cours de cette étape, il s'agit de déterminer au moins un schéma d'exploitation des hydrocarbures contenus dans la bassin sédimentaire étudié. De manière générale, un schéma d'exploitation comprend un nombre, une géométrie et une implantation (position et espacement) des puits injecteurs et producteurs à forer dans le bassin. Un schéma d'exploitation peut en outre comprendre un type de récupération assistée des hydrocarbures contenus dans le ou les réservoirs du bassin, telle qu'une récupération assistée au moyen de l'injection d'une solution comprenant un ou des polymères, de la mousse de $CO_2$, etc. Un schéma d'exploitation d'un réservoir d'hydrocarbures d'un bassin doit par exemple permettre un fort taux de récupération des hydrocarbures piégés dans ce réservoir, sur une longue durée d'exploitation, et nécessitant un nombre de puits limité. Autrement dit, le spécialiste prédéfinit des critères d'évaluation selon lesquels un schéma d'exploitation des hydrocarbures présents dans un réservoir d'un bassin sédimentaire est considéré comme suffisamment performant pour être mis en œuvre.

Selon un mode de mise en œuvre de l'invention, on définit une pluralité de schémas d'exploitation des hydrocarbures contenus dans un ou des réservoirs géologiques du bassin étudié et on estime, à l'aide d'un simulateur de réservoir (tel que le logiciel PUMAFLOW® (IFP Energies nouvelles, France)) au moins un critère d'évaluation de ces schémas d'exploitation. Ces critères d'évaluation peuvent comprendre la quantité d'hydrocarbures produit pour chacun des différents schémas d'exploitation, la courbe représentative de l'évolution de la production dans le temps au niveau de chacun des puits envisagés, le rapport huile sur gaz (GOR) au niveau de chaque puits envisagé etc. Le schéma selon lequel les hydrocarbures contenus dans le ou les réservoirs du bassin étudié sont réellement exploités peut alors correspondre à celui satisfaisant au moins un des critères d'évaluation des différentes schémas d'exploitation.

Puis, une fois un schéma d'exploitation déterminé, les hydrocarbures piégés dans le ou les réservoirs pétroliers du bassin sédimentaire étudié sont exploités en fonction de ce schéma d'exploitation, notamment au moins en forant les puits injecteurs et producteurs du schéma d'exploitation ainsi déterminés, et en installant les infrastructures de production nécessaires au développement de ce ou ces réservoirs. Dans le cas où le schéma d'exploitation a en outre été déterminé en estimant la production d'un réservoir associée à différents types de récupération assistée, on injecte dans le puits injecteur le ou les types d'additifs (polymères, tensio-actifs, mousse de $CO_2$ etc) sélectionnés.

Il est bien entendu qu'un schéma d'exploitation des hydrocarbures d'un bassin peut être évolutif sur la durée de l'exploitation des hydrocarbures de ce bassin, en fonction par exemple de connaissances additionnelles relatives au bassin acquises pendant cette exploitation, des améliorations dans les différents domaines techniques intervenant lors d'une exploitation d'un gisement d'hydrocarbures (améliorations dans le domaine du forage, de la récupération assistée par exemple).

**Equipement et produit programme d'ordinateur**

Le procédé selon l'invention est mis en œuvre au moyen d'un équipement (par exemple un poste de travail informatique) comprenant des moyens de traitement des données (un processeur) et des moyens de stockage de données (une mémoire, en particulier un disque dur), ainsi qu'une interface d'entrée et de sortie pour saisir des données et restituer les résultats du procédé.

Les moyens de traitement de données sont configurés pour réaliser en particulier l'étape 2 décrite ci-dessus.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé tel que décrit précédemment, et notamment l'étape 2) ci-dessus, lorsque ledit programme est exécuté sur un ordinateur.

Ainsi le procédé selon le premier aspect de l'invention permet de stabiliser une simulation numérique de bassin résolvant au moins une équation d'équilibre de la poromécanique selon une méthode aux éléments finis lissée basée sur les faces, dans le cas d'un maillage hexa-dominant, et ce, même dans le cas de couches géologiques du bassin sédimentaire fines et/ou présentant un biseau stratigraphique.

Par ailleurs, le procédé selon le deuxième aspect de l'invention permet de prédire le potentiel pétrolier de bassins sédimentaires complexes, ayant par exemple subi des mouvements tectoniques complexes et présentant des couches fines et/ou des biseaux stratigraphiques, ce qui contribue à améliorer l'exploitation des hydrocarbures de ce type de bassins sédimentaires.

**Revendications**

**1.**  Procédé de modélisation d'un bassin sédimentaire, ledit bassin sédimentaire ayant subi une pluralité d'événements géologiques définissant une séquence d'états dudit bassin, au moyen d'une simulation numérique de bassin exécutée sur ordinateur, ladite simulation numérique de bassin résolvant au moins une équation d'équilibre de la poromécanique selon une méthode aux éléments finis lissée basée sur les faces pour déterminer au moins un champ de contrainte et un champ de déformation, **caractérisé en ce que** le procédé comprend la mise en œuvre d'au moins les étapes suivantes :

A. on réalise des mesures de grandeurs physiques relatives audit bassin au moyen de capteurs, et on construit une première représentation maillée représentative dudit bassin pour chacun desdits états dudit bassin, lesdites premières représentations maillées dudit bassin pour chacun desdits états étant majoritairement formées par des mailles hexaédriques ;

B. au moyen de ladite simulation numérique de bassin et desdites premières représentations maillées pour chacun desdits états, on détermine au moins un champ de déformation et un champ de contrainte pour chacun desdits états en appliquant au moins les étapes suivantes pour chacune desdites premières représentations maillées desdits états

a) on détermine une deuxième représentation maillée dudit état en subdivisant chacune desdites mailles hexaédriques de ladite première représentation maillée dudit état en six mailles pyramidales, lesdites mailles non hexaédriques de ladite première représentation maillée étant inchangées dans ladite deuxième représentation maillée ;

b) on modélise ledit bassin en déterminant au moins ledit champ de déplacement et ledit champ de contrainte pour ledit état au moyen de ladite simulation numérique appliquée à ladite deuxième représentation maillée dudit état.

**2.**  Procédé selon la revendication 1, dans lequel on subdivise une maille hexaédrique de ladite première représentation maillée en six mailles pyramidales en reliant, pour chacune des faces de ladite maille hexaédrique; chacun des nœuds de ladite face à un nœud supplémentaire placé au barycentre de ladite maille hexaédrique.

**3.**  Procédé selon l'une des revendications précédentes, dans lequel, à l'étape b), pour chacune des faces de chacune desdites mailles de ladite deuxième représentation maillée dudit état, on détermine un domaine de lissage relatif à ladite méthode aux éléments finis lissée basée sur les faces en reliant chacun des nœuds de ladite face à au moins un nœud supplémentaire placé au barycentre de ladite au moins une maille à laquelle appartient ladite face.

4. Procédé selon la revendication 3, dans lequel, ledit domaine de lissage pour une face appartenant à au moins une maille pyramidale de ladite deuxième représentation maillée correspond à au moins un tétraèdre ou une pyramide.

5. Produit programme d'ordinateur téléchargeable depuis un réseau de communication et/ou enregistré sur un support lisible par ordinateur et/ou exécutable par un processeur, comprenant des instructions de code de programme pour la mise en œuvre de l'étape B), lorsque ledit programme est exécuté sur un ordinateur.

6. Procédé pour exploiter des hydrocarbures présents dans un bassin sédimentaire, ledit procédé comprenant au moins la mise en œuvre du procédé de modélisation dudit bassin selon l'une des revendications 1 à 4, et dans lequel, à partir au moins de ladite modélisation dudit bassin sédimentaire, on détermine un schéma d'exploitation dudit bassin comprenant au moins une implantation d'au moins un puits injecteur et/ou d'au moins un puits producteur, et on exploite lesdits hydrocarbures dudit bassin au moins en forant lesdits puits de ladite implantation et en les équipant d'infrastructures d'exploitation.

**Patentansprüche**

1. Verfahren zur Modellierung eines Sedimentbeckens, wobei das Sedimentbecken eine Mehrzahl von geologischen Ereignissen erfahren hat, die eine Abfolge von Zuständen des Beckens definieren, mittels einer digitalen Beckensimulation, die am Computer ausgeführt wird, wobei die digitale Beckensimulation wenigstens eine Gleichgewichtsgleichung der Poromechanik gemäß einer flächenbasierten geglätteten Finite-Elemente-Methode löst, um wenigstens ein Spannungsfeld und ein Verformungsfeld zu bestimmen, **dadurch gekennzeichnet, dass** das Verfahren die Durchführung wenigstens der folgenden Schritte umfasst:

A. Es werden Messungen physikalischer Größen bezogen auf das Becken mittels Sensoren durchgeführt, und es wird eine erste Gitterdarstellung, die für das Becken repräsentativ ist, für jeden der Zustände des Beckens erstellt, wobei die ersten Gitterdarstellungen des Beckens für jeden der Zustände mehrheitlich von hexaedrischen Maschen gebildet sind;
B. Mittels der digitalen Beckensimulation und der ersten Gitterdarstellungen für jeden der Zustände wird wenigstens ein Verformungsfeld und ein Spannungsfeld für jeden der Zustände bestimmt, indem wenigstens die folgenden Schritte für jede der ersten Gitterdarstellungen der Zustände angewandt werden:

a) Es wird eine zweite Gitterdarstellung des Zustands bestimmt, indem jede der hexaedrischen Maschen der ersten Gitterdarstellung des Zustands in sechs pyramidenförmige Maschen unterteilt wird, wobei die nicht-hexaedrischen Maschen der ersten Gitterdarstellung in der zweiten Gitterdarstellung unverändert sind;
b) Das Becken wird unter Bestimmung wenigstens des Verschiebungsfelds und des Spannungsfelds für den Zustand mittels der digitalen Simulation modelliert, die auf die zweite Gitterdarstellung des Zustands angewandt wird.

2. Verfahren nach Anspruch 1, wobei eine hexaedrische Masche der ersten Gitterdarstellung in sechs pyramidenförmige Maschen unterteilt wird, indem für jede der Flächen der hexaedrischen Masche; jeder der Knoten der Fläche mit einem zusätzlichen Knoten verbunden wird, der im Baryzentrum der hexaedrischen Masche platziert ist.

3. Verfahren nach einem der vorhergehenden Ansprüche, wobei bei Schritt b) für jede der Flächen jeder der Maschen der zweiten Gitterdarstellung des Zustands ein Glättungsbereich bezogen auf die flächenbasierte geglättete Finite-Elemente-Methode bestimmt wird, indem jeder der Knoten der Fläche mit mindestens einem zusätzlichen Knoten verbunden wird, der im Baryzentrum der wenigstens einen Masche platziert ist, zu welcher die Fläche gehört.

4. Verfahren nach Anspruch 3, wobei der Glättungsbereich für eine Fläche, die zu wenigstens einer pyramidenförmigen Masche der zweiten Gitterdarstellung gehört, wenigstens einem Tetraeder oder einer Pyramide entspricht.

5. Computerprogrammprodukt, das aus einem Kommunikationsnetz heruntergeladen werden kann und/oder auf einem computerlesbaren Datenträger gespeichert ist und/oder von einem Prozessor ausgeführt werden kann, umfassend Programmcode-Anweisungen für die Umsetzung des Schritts B), wenn das Programm auf einem Computer ausgeführt wird.

**6.** Verfahren zur Ausbeutung von Kohlenwasserstoffen, die in einem Sedimentbecken vorhanden sind, wobei das Verfahren wenigstens die Durchführung des Verfahrens zur Modellierung des Beckens nach einem der Ansprüche 1 bis 4 umfasst, und wobei anhand wenigstens der Modellierung des Sedimentbeckens ein Ausbeutungsschema des Beckens bestimmt wird, das wenigstens eine Anordnung von wenigstens einem Injektionsbrunnen und/oder wenigstens einem Produktionsbrunnen umfasst, und die Kohlenwasserstoffe des Beckens wenigstens durch Bohrung der Brunnen der Anordnung und durch Ausstattung dieser mit Ausbeutungsinfrastrukturen ausgebeutet werden.

**Claims**

**1.** Process for modelling a sedimentary basin, said sedimentary basin having undergone a plurality of geological events defining a sequence of states of said basin, by means of a digital basin simulation executed on a computer, said digital basin simulation solving at least one poromechanics equilibrium equation according to a face-based smoothed finite element method in order to determine at least one strain field and one deformation field, **characterized in that** the process comprises implementing at least the following steps:

A. measurements are made of physical quantities relating to said basin by means of sensors, and a first meshed representation which is representative of said basin is constructed for each of said states of said basin, said first meshed representations of said basin for each of said states being predominantly formed by hexahedral meshes;
B. by means of said digital basin simulation and said first meshed representations for each of said states, at least one deformation field and one strain field are determined for each of said states by applying at least the following steps for each of said first meshed representations of said states:

a) a second meshed representation of said state is determined by subdividing each of said hexahedral meshes of said first meshed representation of said state into six pyramidal meshes, said non-hexahedral meshes of said first meshed representation being unchanged in said second meshed representation;
b) said basin is modelled by determining at least said displacement field and said strain field for said state by means of said digital simulation applied to said second meshed representation of said state.

**2.** Process according to Claim 1, wherein a hexahedral mesh of said first meshed representation is subdivided into six pyramidal meshes by linking, for each of the faces of said hexahedral mesh, each of the nodes of said face to an additional node placed at the barycentre of said hexahedral mesh.

**3.** Process according to one of the preceding claims, wherein, in step b), for each of the faces of each of said meshes of said second meshed representation of said state, a smoothing domain relating to said face-based smoothing finite element method is determined by linking each of the nodes of said face to at least one additional node placed at the barycentre of said at least one mesh to which said face belongs.

**4.** Process according to Claim 3, wherein said smoothing domain for a face belonging to at least one pyramidal mesh of said second meshed representation corresponds to at least one tetrahedron or one pyramid.

**5.** Computer program product which can be downloaded from a communication network and/or is stored on a computer-readable medium and/or can be executed by a processor, comprising program code instructions for implementing step B), when said program is executed on a computer.

**6.** Process for exploiting hydrocarbons which are present in a sedimentary basin, said process comprising at least implementing the process for modelling said basin according to one of Claims 1 to 4, and wherein, on the basis of at least said modelling of said sedimentary basin, an exploitation scheme for said basin is determined, comprising at least one site of at least one injection well and/or of at least one production well, and said hydrocarbons of said basin are exploited at least by drilling said wells of said site and by equipping them with exploitation infrastructures.

[Fig. 1]

[Fig 2]

[Fig 3]

[Fig 4]

[Fig 5]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017177764 A1
- EP 2110686 A
- US 8150669 B
- EP 2816377 A
- US 20140377872 A
- EP 3075947 A

- US 20160290107 A
- EP 3182176 A
- US 20170177764 A
- US 10296679 B
- FR 2930350 A1
- US 20090265152 A1

**Littérature non-brevet citée dans la description**

- **COOK, ROBERT D.** Finite Element Modeling for Stress Analysis. John Wiley & Sons, 1995
- **COUSSY, O.** Mécanique des milieux poreux. 1991
- **LIU, G.R.** Nguyen Thoi Trung, Smoothed Finite Element Methods. CRC Press, 2010
- **SCHNEIDER F.** Modelling multi-phase flow of petroleum at the sedimentary basin scale. *Journal of Geochemical exploration,* 2003, vol. 78-79, 693-696

- **STECKLER, M.S. ; A.B. WATTS.** Subsidence of the Atlantic-type continental margin off New York. *Earth Planet. Sci. Lett.,* 1978, vol. 41 (1-13
- **ZIENKIEWICZ, O.C. ; TAYLOR, R.L.** The finite element method - Volume 1 : the basis-Fifth Edition. Butterworth Heinemann, 2000
- **LI, Y H ; NIU, R P ; LIU, G R.** *Highly accurate smoothed finite element methods based on simplificd eight-noded hexahedron éléments EngineeringAnalysis with Boundary Eléments,* 2019, vol. 105, 165-177